**Europäisches Patentamt**

**European Patent Office**

**Office européen des brevets**

(19)

(11) Numéro de publication : **0 238 141 B1**

(12)
# FASCICULE DE BREVET EUROPEEN

(45) Date de publication du fascicule du brevet :
**09.01.91 Bulletin 91/02**

(51) Int. Cl.⁵ : **H03D 3/24**

(21) Numéro de dépôt : **87200471.8**

(22) Date de dépôt : **13.03.87**

(54) Récepteur de signaux modulés en fréquence.

(30) Priorité : **21.03.86 FR 8604077**

(43) Date de publication de la demande :
**23.09.87 Bulletin 87/39**

(45) Mention de la délivrance du brevet :
**09.01.91 Bulletin 91/02**

(84) Etats contractants désignés :
**DE FR GB**

(56) Documents cités :
**EP-A- 0 199 887**
**GB-A- 2 079 552**
**US-A- 3 517 268**
**PATENT ABSTRACTS OF JAPAN, vol. 7, no. 272 (E-214)[1417], 3 décembre 1983; & JP-A-58 151 717 (MATSUSHITA DENKI SANGYO K.K.) 09-09-1983**

(73) Titulaire : **LA RADIOTECHNIQUE PORTENSEIGNE**
**51, Rue Carnot**
**F-92150 Suresnes (FR)**
**FR**
Titulaire : **N.V. Philips' Gloeilampenfabrieken**
**Groenewoudseweg 1**
**NL-5621 BA Eindhoven (NL)**
**DE GB**

(72) Inventeur : **Horvat, Philippe**
**Société Civile S.P.I.D. 209 rue de l'Université**
**F-75007 Paris (FR)**

(74) Mandataire : **Landousy, Christian et al**
**Société Civile S.P.I.D. 156, Boulevard Haussmann**
**F-75008 Paris (FR)**

## Description

La présente invention concerne un récepteur de signaux modulés en fréquence comprenant un circuit de sélection de canal et de fréquence intermédiaire connecté à un démodulateur de fréquence à boucle à verrouillage de phase, et une connexion de retour vers ledit circuit de sélection de canal pour constituer une boucle à verrouillage de fréquence.

Un tel récepteur est connu par exemple de la demande de brevet anglais GB-A-2079552. La structure décrite dans ce document fait cependant appel à trois détecteurs de phase distincts pour la détermination du signal de correction, dont deux participent à la construction dudit signal de correction et dont le troisième commande l'envoi de ce dernier vers le circuit de sélection.

Le but de l'invention est de proposer un récepteur de signaux modulés en fréquence de structure et de fonctionnement plus simples que ceux de la réalisation connue du document cité, et qui offre quand même une durée de plage de capture de la porteuse relativement brève.

Le récepteur de signaux modulés en fréquence selon l'invention est à cet effet caractérisé en ce qu'il comporte également un étage de correction de tension de commande comprenant lui-même d'une part un comparateur des signaux délivrés respectivement, par l'intermédiaire de diviseurs, par l'oscillateur de la boucle à verrouillage de phase et par un oscillateur de référence, et d'autre part au moins un intégrateur prévu en sortie dudit comparateur et dont la sortie est reliée à la fois à l'entrée de l'oscillateur de la boucle à verrouillage de fréquence et à un additionneur inséré dans la boucle à verrouillage de phase entre la sortie du démodulateur et l'oscillateur de cette boucle.

Dans le récepteur proposé, la simplification de structure est obtenue notamment par le fait que la capture de fréquence n'exige plus d'actions de commutation de réseaux de résistance fixant la tension de commande de l'oscillateur de la boucle à verrouillage de fréquence. Par ailleurs, la réduction de plage de capture est obtenue à l'aide d'un précentrage du démodulateur de fréquence, par comparaison de la fréquence de l'oscillateur de ce démodulateur à une fréquence de référence. Ce précentrage rétroagit, même en l'absence de la porteuse, pour précentrer l'oscillateur de la boucle à verrouillage de phase du démodulateur.

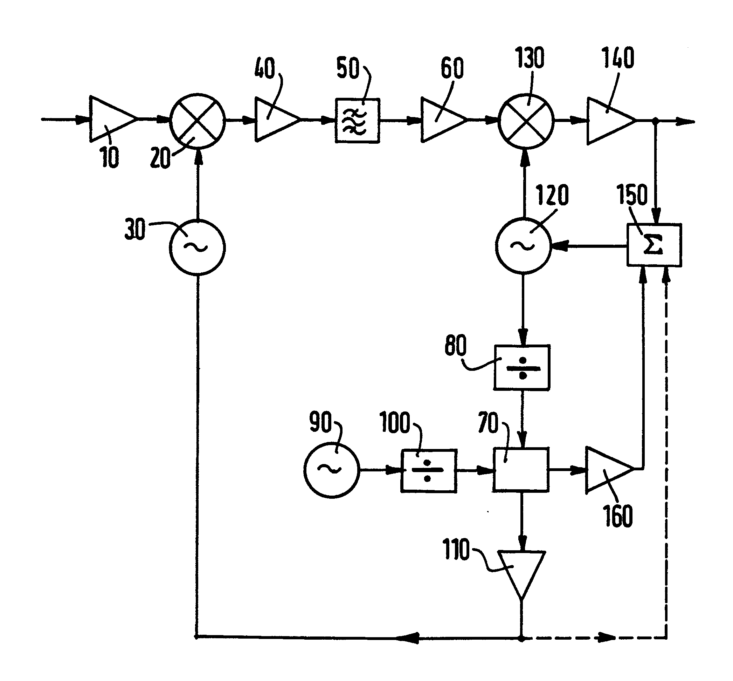

Les particularités de l'invention apparaîtront maintenant de façon plus précise dans la description qui suit et dans la figure annexée, donnée à titre d'exemple non limitatif et qui montre un mode de réalisation du récepteur selon l'invention.

Le récepteur de signaux modulés en fréquence représenté sur cette figure annexée comprend d'abord un circuit de sélection de canal et de fréquence intermédiaire, composé lui-même d'un mélangeur 20, dont les entrées sont reliées d'une part à un amplificateur 10 recevant le signal modulé en fréquence à une fréquence porteuse déterminée et d'autre part à un oscillateur 30, d'un amplificateur 40, d'un filtre passebande 50, et d'un circuit de commande automatique de gain 60, prévus en série. Le récepteur comprend également, en sortie de ce circuit 60, un démodulateur de fréquence à boucle à verrouillage de phase, ladite boucle étant équipée elle-même d'un oscillateur 120 à commande par la tension, d'un mélangeur 130 recevant d'une part la sortie du circuit de sélection et d'autre part celle de l'oscillateur 120, et d'un filtre de boucle 140.

Dans une connexion de retour vers le circuit de sélection, connexion qui permet de constituer une boucle à verrouillage de fréquence, le récepteur comprend encore, conformément à l'invention, un étage de correction de tension de commande, comprenant lui-même des éléments 70 à 110 et 150 et 160. Le comparateur 70 reçoit d'une part le signal à la fréquence à comparer, par l'intermédiaire d'un premier diviseur de fréquence 80, et d'autre part un signal à une fréquence de référence, par l'intermédiaire d'un oscillateur de référence 90 et d'un deuxième diviseur de fréquence 100. La sortie du comparateur 70 est envoyée vers un intégrateur 110 qui génère le signal de tension de commande de l'oscillateur 30 de la boucle à verrouillage de fréquence. L'étage de correction de tension de commande comprend aussi un additionneur 150 dont la sortie est reliée à l'entrée dudit oscillateur de la boucle à verrouillage de phase et dont les entrées sont reliées d'une part à la sortie de cette boucle, qui est aussi celle du démodulateur, et d'autre part à la sortie d'un deuxième intégrateur 160 relié à la sortie du comparateur 70. On pourrait également n'utiliser, dans le même but, que l'intégrateur 110 déjà revu (connexion représentée en trait interrompu.)

Le fonctionnement du récepteur selon l'invention va être maintenant décrit. En l'absence de porteuse incidente, l'étage de correction de tension de commande impose à l'oscillateur 120 la fréquence de consigne fixée par l'oscillateur 90 et qui correspond à la fréquence centrale $F_l$ du filtre 50. Lors de l'apparition de la porteuse, le processus de capture devient le suivant :

(a) à la mise sous tension, le circuit de correction de tension de commande impose à l'oscillateur de la boucle à verrouillage de phase la fréquence $F_l$ ;

(b) à l'apparition de la fréquence porteuse, cette boucle se verrouille sur cette fréquence ;

(c) l'étage de correction ramène alors la porteuse et la fréquence de l'oscillateur 120 vers la valeur de la fréquence de référence.

On obtient ainsi une plage de capture effectivement réduite. Par ailleurs, à l'apparition de la porteuse, le milieu de cette plage de capture coïncide avec la fréquence centrale du filtre 50 de fréquence intermédiaire. Enfin, la tension parasite de décalage due à l'amplitude de la porteuse n'intervient plus, et les dérives en fréquence de l'oscillateur de la boucle à verrouillage de phase sont désormais compensées quel que soit le gain de cette boucle.

## Revendications

1. Récepteur de signaux modulés en fréquence comprenant un circuit (10 à 60) de sélection de canal et de fréquence intermédiaire connecté à un démodulateur de fréquence (120 à 140) à boucle à verrouillage de phase, et une connexion de retour vers ledit circuit de sélection de canal pour constituer une boucle à verrouillage de fréquence, caractérisé en ce qu'il comporte également un étage de correction de tension de commande comprenant lui-même d'une part un comparateur (70) des signaux délivrés respectivement, par l'intermédiaire de diviseurs (80, 100), par l'oscillateur (120) de la boucle à verrouillage de phase et par un oscillateur de référence (90), et d'autre part au moins un intégrateur prévu en sortie dudit comparateur et dont la sortie est reliée à la fois à l'entrée de l'oscillateur (30) de la boucle à verrouillage de fréquence et à un additionneur (150) inséré dans la boucle à verrouillage de phase entre la sortie du démodulateur et l'oscillateur (120) de cette boucle.

2. Récepteur selon la revendication 1, caractérisé en ce qu'il comprend en sortie du comparateur (70) deux intégrateurs (110, 160) reliés respectivement à l'entrée de l'oscillateur (30) de la boucle à verrouillage de fréquence et à l'entrée de l'additionneur (150).

## Ansprüche

1. Empfänger für frequenzmodulierte Signale mit einem mit einem Frequenzdemodulator (120 bis 140) in Form einer Phasenverriegelungsschleife verbundenen Kanal- und Zwischenfrequenzwahlkreis (10 bis 60), und mit einer Rückverbindung zu dem genannten Kanalwahlkreis zum Bilden einer Frequenzverriegelungsschleife, dadurch gekennzeichnet, daß der Empfänger ebenfalls eine Steuerspannungskorrekturstufe aufweist, die einerseits eine Vergleichsschaltung (70) für Signale aufweist, die mittels Teilerschaltungen (80, 100), mittels des Oszillators (120) der Phasenverriegelungsschleife und mittels eines Bezugsoszillators (90) geliefert werden, und andererseits mindestens einen Integrator am Ausgang der genannten Vergleichsschaltung, dessen Ausgang mit dem Eingang des Oszillators (30) der Frequenzverriegelungsschleife, sowie mit einem Addierer (150) verbunden ist, der in der phasenverriegelungsschleife zwischen dem Ausgang des Demodulators und des Oszillators (120) dieser Schleife vorgesehen ist.

2. Empfänger nach Anspruch 1, dadurch gekennzeichnet, daß er am Ausgang der Vergleichsschaltung (70) zwei Integrationsschaltungen (110, 160) aufweist, die mit dem Eingang des Oszillators (30) der Frequenzverriegelungsschleife bzw. dem Eingang des Addierers (150) verbunden sind

## Claims

1. A receiver for frequency-modulated signals comprising an intermediate frequency channel selection circuit (10 to 60) connected to a phase-locked loop frequency demodulator (120 to 140) and a feedback connection to said channel selection circuit for constituting a frequency-locked loop, characterized in that it also comprises a control voltage correction stage including a comparator (70) for signals supplied via dividers (80, 100), from the oscillator (120) of the phaselocked loop and from a reference oscillator (90), respectively, and at least an integrator at the output of said comparator, which integrator has its output connected to the input of the oscillator (30) of the frequency-locked loop and to an adder (150) arranged in the phase-locked loop between the output of the demodulator and the oscillator (120) of said loop.

2. A receiver as claimed in Claim 1, characterized in that it comprises at the output of the comparator (70) two integrators (110, 160) connected to the input of the oscillator (30) of the frequency-locked loop and to the input of the adder (150), respectively.